# EUROPEAN PATENT APPLICATION

(11) **EP 4 700 249 A1**
(43) Date of publication of application: **25.02.2026**
(21) Application number: 25196902.8
(22) Date of filing: 20.08.2025
(51) Int. Cl.: F04D 33/00, F04B 19/00

(54) **AIRFLOW GENERATING DEVICE AND METHOD THEREOF**

(30) Priority: 20.08.2024 US 202463684879 P; 27.12.2024 US 202463739137 P; 19.08.2025 US 202519303389
(71) Applicant: Xmems Labs, Inc., Santa Clara, CA 95051 (US)
(72) Inventor: Tseng, Kuan-Ju, 300 Hsinchu City (TW); Ren, Jye, 106 Taipei City (TW); Chen, Wen-Chien, 232 New Taipei City (TW)
(74) Representative: Straus, Alexander

(57) **Abstract**

An airflow generating device includes a first cell and a second cell. The first cell is disposed within a first region and generates a first air pressure with a first polarity. The second cell is disposed within a second region and generates a second air pressure with a second polarity. The second polarity is opposite to the first polarity.

## Description

### Field of the Invention

The present application relates to an airflow generating device and a method thereof, and more particularly, to an airflow generating device and a method thereof capable of providing significant airflow.

### Background of the Invention

Unless otherwise indicated herein, the approaches described in this section are not prior art to the claims in this application and are not admitted as prior art by inclusion in this section.

Air pulse generating (APG) devices generating air pulses have been developed. Besides audio application, air pulse generating devices may be used for airflow application. MEMS-fabricated (MEMS: Micro electro mechanical Systems) APG devices have recently attracted significant market attention due to tiny size and ability to generate airflow. To improve performance like heat dissipation, there is a high market demand for strong airflow. Providing significant airflow would be a challenge for micro devices using MEMS fabrication.

Therefore, how to design a MEMS device capable of providing significant airflow is an objective in the field.

### Summary of the Invention

It is therefore a primary objective of the present application to provide an airflow generating device and a method thereof, to improve over disadvantages of the prior art.

The present invention provides an airflow generating device comprising a first cell and a second cell. The first cell is disposed within a first region and generates a first air pressure with a first polarity. The second cell is disposed within a second region and generates a second air pressure with a second polarity, wherein the second polarity is opposite to the first polarity.

The present invention provides a method of generating airflow for an airflow generating device comprising generating, by a first cell, a first air pressure with a first polarity in a first region; and generating, by a second cell, a second air pressure with a second polarity in a second region; wherein the airflow generating device comprises the first cell and the second cell; wherein the second polarity is opposite to the first polarity.

The present invention provides an airflow generating device comprising a film structure, configured to perform a movement to push or pull a volume over the film structure to generate a positive pressure and a negative pressure; a flap pair, comprising a first flap and a second flap opposite to each other, configured to perform a differential movement to form a virtual valve; wherein the differential movement performed by the flap pair is synchronized with the movement performed by the film structure; wherein an airflow is formed when the virtual valve is opened.

### Brief Description of the Drawings

FIG. 1 is a schematic diagram of a top view of an airflow generating device according to an embodiment of the present application.
FIG. 2 is a schematic diagram of a cross-sectional view of an airflow generating device according to an embodiment of the present application.
FIG. 3 illustrates membrane movement of an airflow generating device according to an embodiment of the present application.
FIG. 4 illustrates driving signals according to an embodiment of the present application.
FIG. 5 is a schematic diagram of an airflow generating device according to an embodiment of the present application.
FIG. 6 is a schematic diagram of airflow generating devices according to an embodiment of the present application.
FIG. 7 is a schematic diagram of an airflow generating device according to an embodiment of the present application.
FIG. 8 is a schematic diagram of an appearance of an airflow generating device according to an embodiment of the present application.
FIG. 9 is a schematic diagram of an airflow generating device according to an embodiment of the present application.
FIG. 10 is a schematic diagram of an airflow generating device according to an embodiment of the present application.
FIG. 11 is a schematic diagram of an airflow generating device according to an embodiment of the present application.

### Detailed Description

Content of US Patent No. 12,356,141 is incorporated herein by reference.

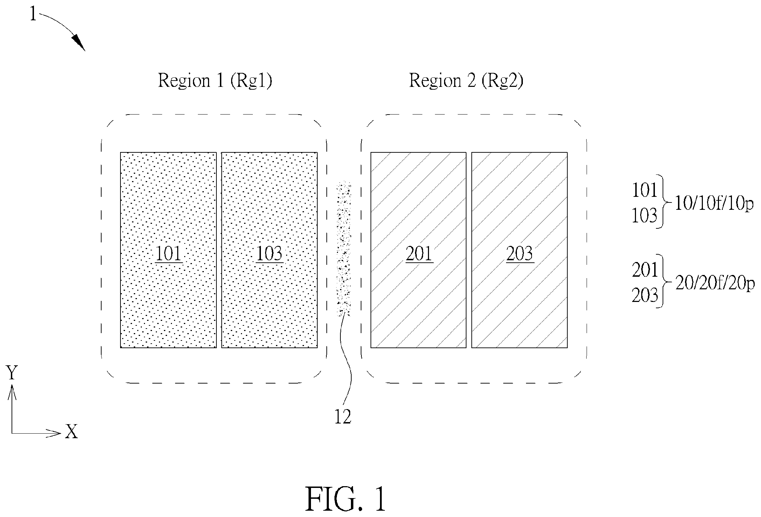

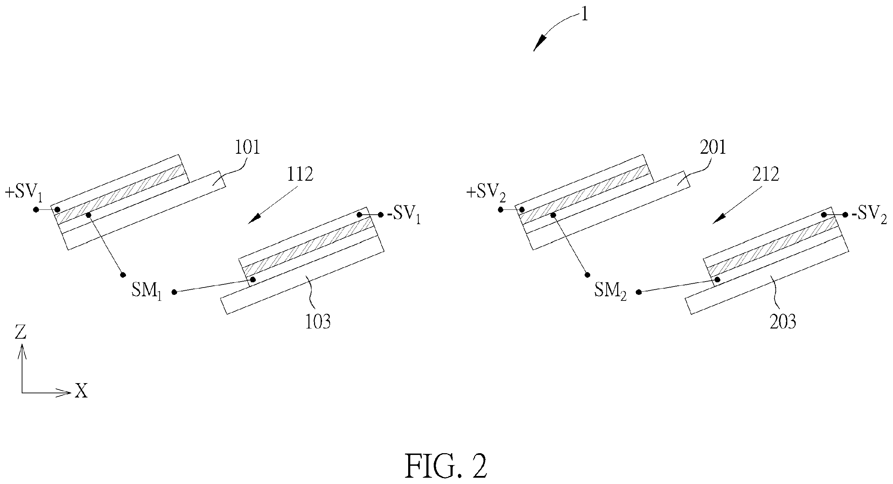

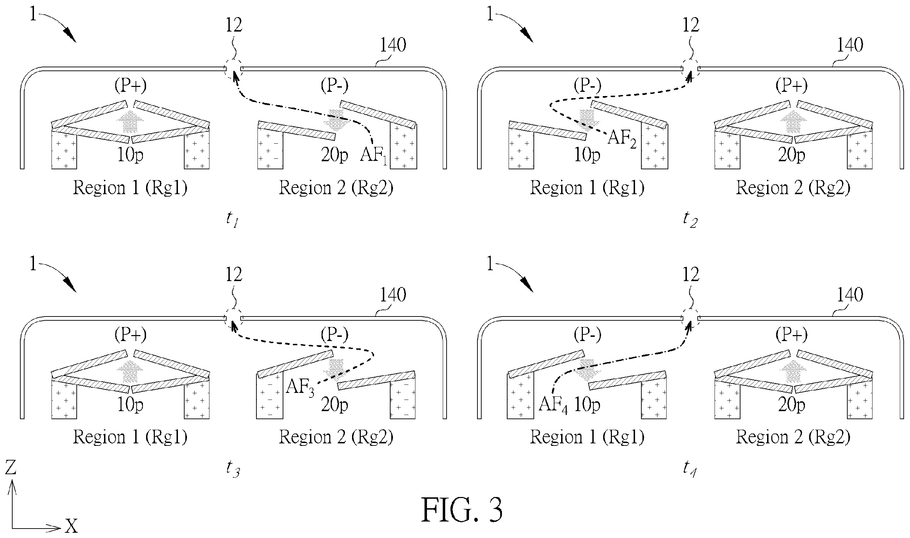

FIG. 1 is a schematic diagram of a top view of an airflow generating device 1 (especially membrane portion) according to an embodiment of the present application. FIG. 2 is a schematic diagram of a cross-sectional view of the airflow generating device 1 (especially membrane portion) according to an embodiment of the present application. FIG. 3 illustrates membrane movement of the airflow generating device 1 (including covering structure 140) according to an embodiment of the present application. The airflow generating device 1 comprises a first cell 10 and a second cell 20. Each of the cells 10 and 20 are MEMS fabricated air pulse generating device, having structure similar to US Patent No. 12,356,141. The first cell 10 is disposed within a first region Rg1 (or Region 1), and the second cell 20 is disposed within a second region Rg2 (or Region 2). As will be seen, the present invention exploits cell(s) in Region 1 and cell(s) in Region 2 to create air pressure difference, so as produce airflow.

Specifically, the cell 10/20 comprise a film structure (or membrane) 10f/20f. In the embodiment shown in FIG. 1, the film structure 10f/20f comprises a flap pair 10p/20p, and the flap pair 10f/20f comprises a first flap 101/201 and a second flap 103/203 opposite to each other.

The flap pair 10p/20p may receive a common-mode signal SM₁/SM₂ (a.k.a., modulation driving signal) to perform a (first/second) common-mode movement. The flap pair 10p/20p may also receive a pair of differential-mode signals ±SV₁/±SV₂ to perform a (first/second) differential-mode movement. In the embodiment shown in FIG. 1 and FIG. 2, the flap pair 10p/20p performs the common-mode movement and the differential-mode movement simultaneously. In fact, actually membrane movement of the flap pair 10p/20p may be viewed as aggregation/combination of the common-mode movement and the differential-mode movement.

In an embodiment, as shown in FIG. 2, the flap pair 10p/20p receives the differential-mode signals ±SV₁/±SV₂ via top electrodes of corresponding actuators and receives the common-mode signal SM₁/SM₂ via bottom electrodes of the corresponding actuators.

The flap pair 10p/20p with opposite flaps 101/201 and 103/203 performs the first/second differential-mode movement for a first/second virtual valve 112/212. The first/second virtual valve 112/212 is considered as "opened" when a displacement difference of the flaps 101/201 and 103/203 is greater than a flap/membrane thickness. The first/second virtual valve 112/212 is considered as "closed" when the displacement difference of the flaps 101/201 and 103/203 is less than the flap/membrane thickness.

In an embodiment, as taught in the No. 12,356,141, the virtual valve is closed during the differential-mode movement is in transition, which means that the virtual valve is closed during transition time period of the first and second flaps performing the differential-mode movement, but not limited thereto. In an embodiment, the virtual valve may be in closed status corresponding to reversal of flap/membrane movement within the differential-mode movement, which is also within the scope of the present invention.

Operational principles of each cell can be referred to US Patent No. 12,356,141, for reference (but not for limitation(s)).

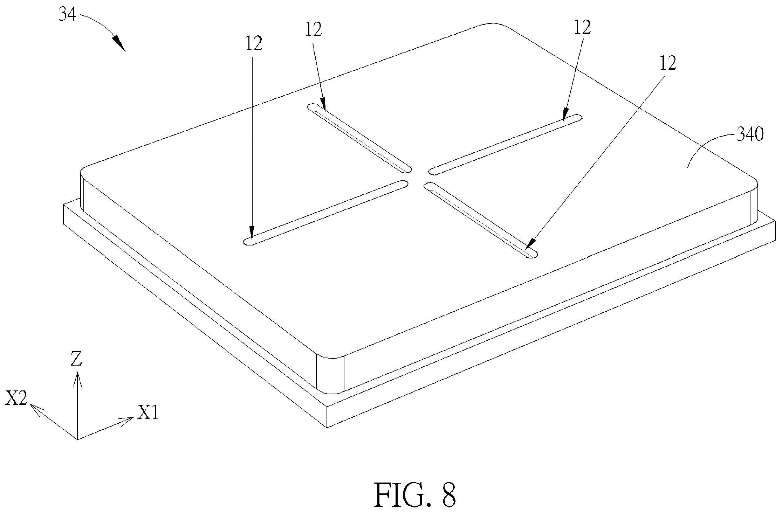

In FIG. 3, covering structure 140, configured to cover the flap pair 10p/20p, is illustrated. Within the covering structure 140, an opening 12 is formed between the first region Rg1 and the second region Rg2, and may have an elongated shape (as shown in FIG. 8). In FIG. 1, (a projection of) the opening 12 is also shown, which is between the first region Rg1 and the second region Rg2.

FIG. 3 illustrates membrane movement of the airflow generating device 1 at times *t₁, t₂, t₃, t*₄ according to an embodiment of the present application.

At time *t*₁, the first cell 10 or the first flap pair 10p performs the first common-mode movement upward and performs the first differential-mode movement such that the first virtual valve 112 is closed. The second cell 20 or the second flap pair 20p performs the second common-mode movement downward and performs the second differential-mode movement such that the second virtual valve 212 is opened. The first common-mode movement moving upward compresses a first volume of/over the first region Rg1 and creates positive air pressure P+ in/over the first region Rg1. The second common-mode movement moving downward expands a second volume of the second region Rg2 and creates negative air pressure P- in/over the second region Rg2. The second differential-mode movement causing the second virtual valve 212 opened allows an airflow AF₁ flowing through the openings 212, 12 toward +Z direction.

At time *t*₂, the first cell 10 or the first flap pair 10p performs the first common-mode movement downward and performs the first differential-mode movement such that the first virtual valve 112 is opened. The second cell 20 or the second flap pair 20p performs the second common-mode movement upward and performs the second differential-mode movement such that the second virtual valve 212 is closed. The second common-mode movement moving upward compresses the second volume of/over the second region Rg2 and creates positive air pressure P+ in/over the second region Rg2. The first common-mode movement moving downward expands the first volume of the first region Rg1 and creates negative air pressure P-in/over the first region Rg1. The first differential-mode movement causing the first virtual valve 112 opened allows an airflow AF₂ flowing through the openings 112, 12 toward +Z direction.

At time *t*₃, the first cell 10 or the first flap pair 10p performs the first common-mode movement upward and performs the first differential-mode movement such that the first virtual valve 112 is closed. The second cell 20 or the second flap pair 20p performs the second common-mode movement downward and performs the second differential-mode movement such that the second virtual valve 212 is opened. The first common-mode movement moving upward compresses the first volume of/over the first region Rg1 and creates positive air pressure P+ in/over the first region Rg1. The second common-mode movement moving downward expands the second volume of the second region Rg2 and creates negative air pressure P- in/over the second region Rg2. The second differential-mode movement causing the second virtual valve 212 opened allows an airflow AF₃ flowing through the openings 212, 12 toward +Z direction.

At time *t*₄, the first cell 10 or the first flap pair 10p performs the first common-mode movement downward and performs the first differential-mode movement such that the first virtual valve 112 is opened. The second cell 20 or the second flap pair 20p performs the second common-mode movement upward and performs the second differential-mode movement such that the second virtual valve 212 is closed. The second common-mode movement moving upward compresses the second volume of/over the second region Rg2 and creates positive air pressure P+ in/over the second region Rg2. The first common-mode movement moving downward expands the first volume of the first region Rg1 and creates negative air pressure P-in/over the first region Rg1. The first differential-mode movement causing the first virtual valve 112 opened allows an airflow AF₄ flowing through the openings 112, 12 toward +Z direction.

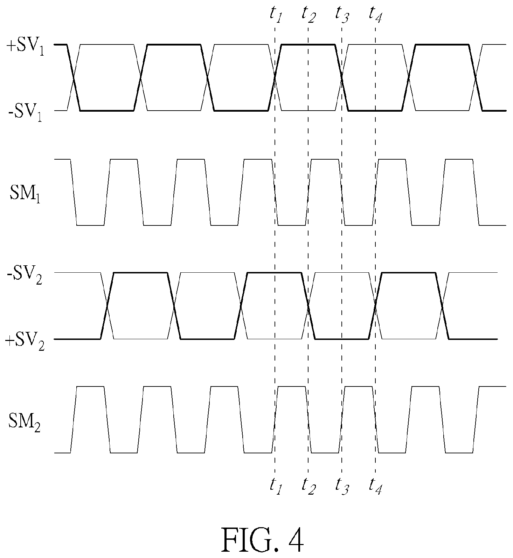

Membrane movement shown in FIG. 3 can be achieved by applying (driving) signals SM₁, SM₂, ±SV₁, ±SV₂ shown in FIG. 4. Signal set (SM_{1/2}, ±SV_{1/2}) may be referred to US Patent No. 12,356,141. A differential-mode frequency of the differential-mode signal ±SV may be a half (or even a quarter) of the common-mode frequency of the common-mode signal SM.

In the embodiment shown in FIG. 4, the differential-mode signal ±SV₁ and the differential-mode signal ±SV₂ may have a phase difference of π/4 (but not limited thereto); the common-mode signal SM₁ and the common-mode signal SM₂ may have a phase difference of π/2 (but not limited thereto).

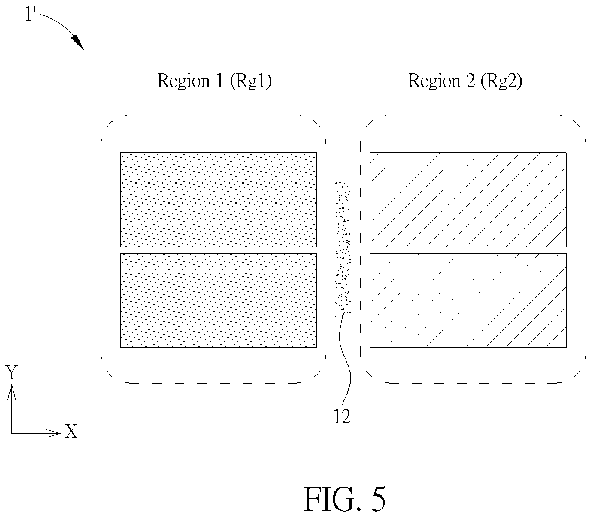

FIGs. 5-7 illustrate top view of airflow generating devices 1', 2, 2' and 3 according to an embodiment of the present application. For the airflow generating devices 1, 1', 2 and 2', where the airflow generating device may be solely partitioned into two regions, cell(s) disposed within Region 1 and receiving a first signal set (SM₁, ±SV₁) may be considered as first cell(s), and cell(s) disposed within Region 2 and receiving a second signal set (SM₂, ±SV₂) may be considered as second cell(s).

In FIG. 5, slit formed between opposite first and second flaps within the first/second cell of airflow generating device 1' is perpendicular to the opening 12, which is also within the scope of the present invention.

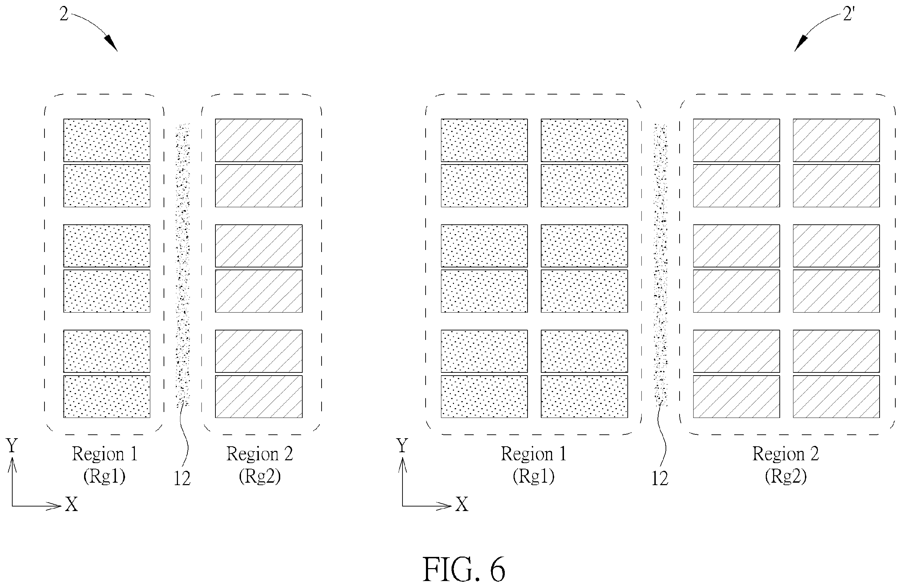

In FIG. 6, in Region 1 there might be a plurality of first cells and in Region 2 there might be a plurality of second cells. The plurality of first/second cells may be arranged as array, which is also within the scope of the present invention.

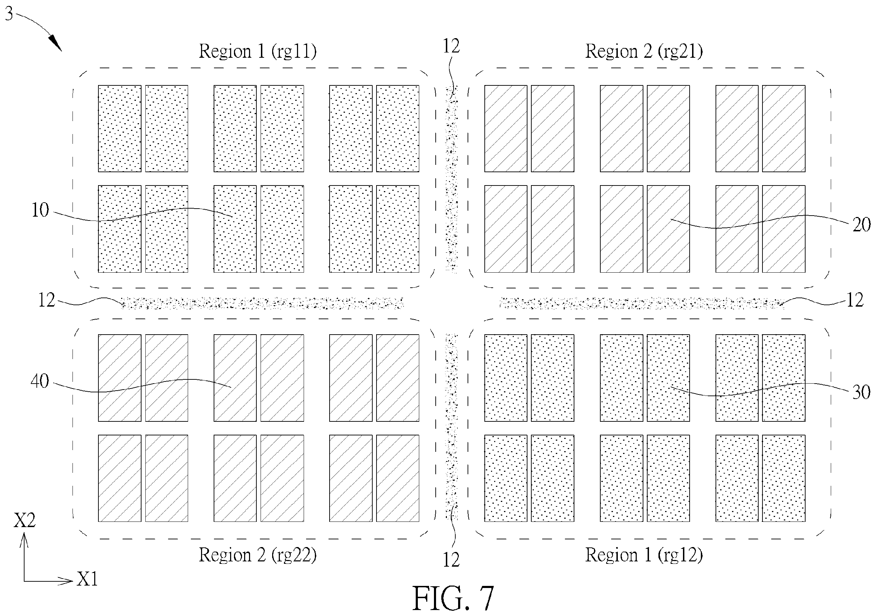

In FIG. 7, cells receiving the first signal set (SM₁, ±SV₁) may be adjacent to cells receiving the second signal set (SM₂, ±SV₂) both in a first direction (e.g., X1) and a second direction (e.g., X2) perpendicular to the first direction (and vice versa). For example, first cells 10 in a sub-region rg11 of Region 1 are adjacent to second cells 20 in a sub-region rg21 of Region 2 in the first direction X1, and the first cells 10 in the sub-region rg11 of Region 1 are adjacent to fourth cells 40 in a sub-region rg22 of Region 2 in the second direction X2 (perpendicular to first direction X1). Similarly, third cells 30 in a sub-region rg12 of Region 1 are adjacent to the fourth cells 40 in the sub-region rg22 of Region 2 in the first direction X1, and the third cells 30 in the sub-region rg12 of Region 1 are adjacent to the second cells in the sub-region rg21 of Region 2 in the second direction X2.

In an embodiment, the first cells in the sub-region rg11 and the third cells in the sub-region rg12 of Region 1 all receives the first signal set (SM₁, ±SV₁), and the second cells in the sub-region rg21 of Region 2 and the second/fourth cells in the sub-region rg22 of Region 2 all receives the second signal set (SM₂, ±SV₂).

The openings 12 may be arranged between Region 1 and Region 2. Specifically, the openings 12 may be arranged between sub-region rg11 of Region 1 and sub-region rg21 of Region 2, between sub-region rg11 of Region 1 and sub-region rg22 of Region 2, between sub-region rg12 of Region 1 and sub-region rg22 of Region 2, and/or between sub-region rg12 of Region 1 and sub-region rg21 of Region 2.

Note that, FIG. 7 is for illustration purpose. Each sub-region (e.g., rg11, rg12, rg21, rg22) may comprise only one cell, which is within the scope of the present invention.

FIG. 8 is a schematic diagram of an appearance of an airflow generating device 34 according to an embodiment of the present application. The airflow generating device 34 comprises a covering structure (e.g., a lid) 340. In the covering structure 340 the openings 12 may be formed, where the openings 12 may have elongated shapes. The elongated openings 12 may partition the airflow generating device 34 into sub-regions rg11, rg12, rg21 and rg22 as shown in FIG. 7, where the covering structure 340 may be used to cover or disposed over the airflow generating device 3 shown in FIG. 7 to form the airflow generating device 34.

An advantage of the present invention is airflow (volume) of the present invention may be scaled up by simply incorporating more cells and extending cells and openings (specifically openings 12) arrangement toward directions X1 and/or X2, which allows the design more flexible to meeting various requirements, and would be more robust to assembly variation and easier to array implementation compared to previous architecture.

Another advantage of the present invention is double differential mode (e.g., airflow generating device 34) would be less ultrasonic energy leakage, compared to previous design, which might bring better airflow performance.

For example, in a simulation three configurations are compared. In the simulation, cell arrangement which is similar to the airflow generating device 3 is considered. First configuration is "common mode", where all cells receive one common signal set (SM, ±SV) (subscript is neglected herein). Second configuration is "differential mode", where cells in subregions rg11 and rg22 (e.g., cell 10 and 40) receives the first signal set (SM₁, ±SV₁) and cells in subregions rg21 and rg12 (e.g., cell 20 and 30) receives the second signal set (SM₂, ±SV₂). Final configuration is "double differential mode", where cells in subregions rg11 and rg12 (e.g., cell 10 and 30) receives the first signal set (SM₁, ±SV₁) and cells in subregions rg21 and rg22 (e.g., cell 20 and 40) receives the second signal set (SM₂, ±SV₂).

In the simulation, "common mode", "differential mode", and "double differential mode" produce airflow (volume velocity) of 45 cc/sec., 54 cc/sec. and 58 cc/sec. (cubic centimeters per second), respectively. As can be seen, "differential mode" configuration (corresponding to present invention) is better than "common mode" (corresponding to previous design which can be regarded as an extension of No. 12,356,141) in terms of airflow or volume velocity performance. Furthermore, the "double differential mode" configuration is even better and "differential mode". In other words, it is validated that both "differential mode" and "double differential mode" improve airflow or volume velocity performance over prior art.

Note that, the embodiments shown in the above are one flap pair performing both common-mode movement and differential-mode movement (simultaneously), which is not limited thereto.

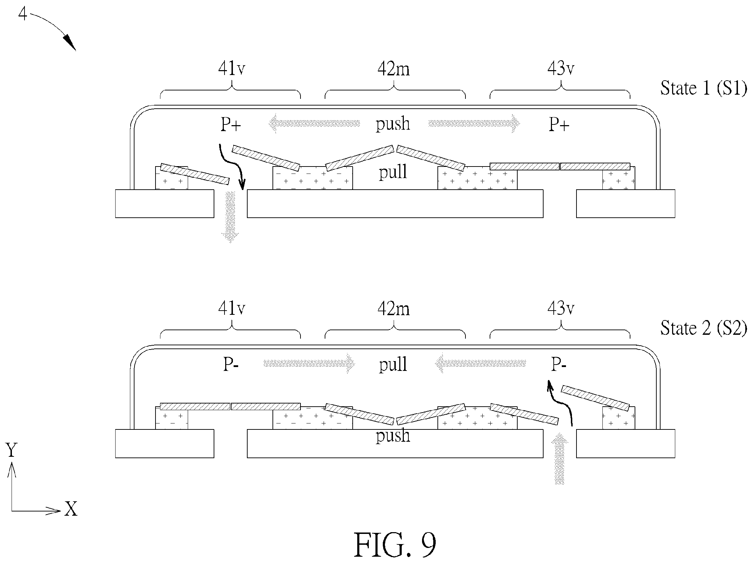

FIGs. 9-11 illustrate airflow generating devices 4-6 according to an embodiment of the present application.

In FIG. 9, the airflow generating device 4 comprises flap pairs 41v, 42m and 43v. The flap pair 42m (solely/mainly) performs common-mode movement to push or pull the volume above/under the flap pair 42m, resulting in positive air pressure P+ and/or negative air pressure P- (especially within the chamber illustrated). The flap pairs 41v and 43v (solely/mainly) perform differential-mode movement. Timing of the common-mode movement of the flap pair 42m and the differential-mode movement of the flap pairs 41v and 43v are synchronized. Therefore, airflow to/from the airflow generating device 4 may be generated.

In an embodiment, the differential-mode frequency may be a half/quarter of the common-mode frequency, so that the opening can always happen at high/low pressure in the enclosure chamber, leading to one-directional airflow pumping.

In an embodiment, the chamber surface may be attached to a heat source or fin structure, such that the air within the chamber may be heated up by the external heat source and blow away, and heat of the heat source may be dissipated.

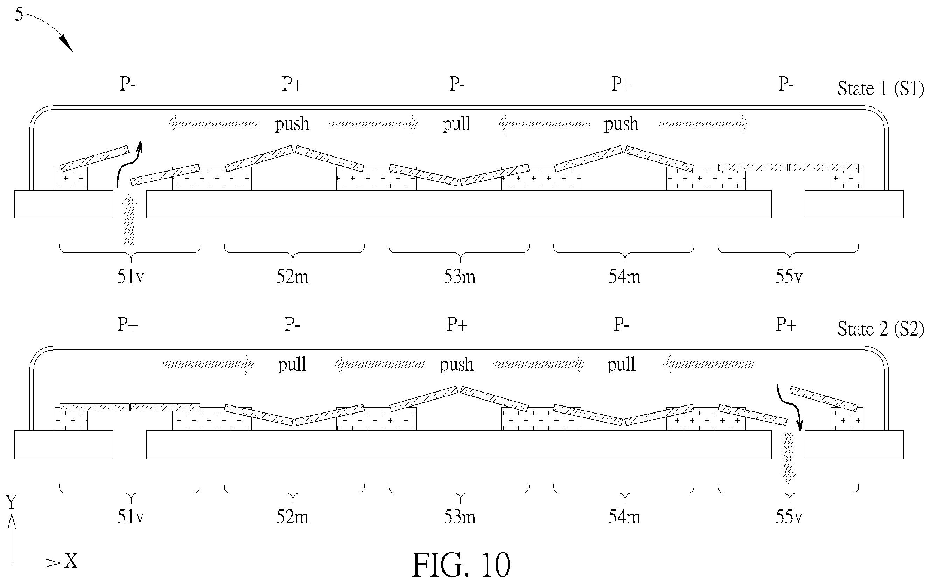

In FIG. 10, the airflow generating device 5 comprises flap pairs 51v, 52m, 53m, 54m and 55v. The flap pairs 52m, 53m and 54m (solely/mainly) perform common-mode movement to push or pull the volume above the flap pairs 52m, 53m and 54m, resulting in positive/negative air pressure P+/P-. The flap pairs 51v and 55v (solely/mainly) perform differential-mode movement, synchronized with the common-mode movement.

The pressure and airflow inside the chamber is similar to a forced swirling system, and it will help increase the equivalent heat convention coefficient of the air in the chamber, helping exhale higher temperature when the top surface is attached to a heat source.

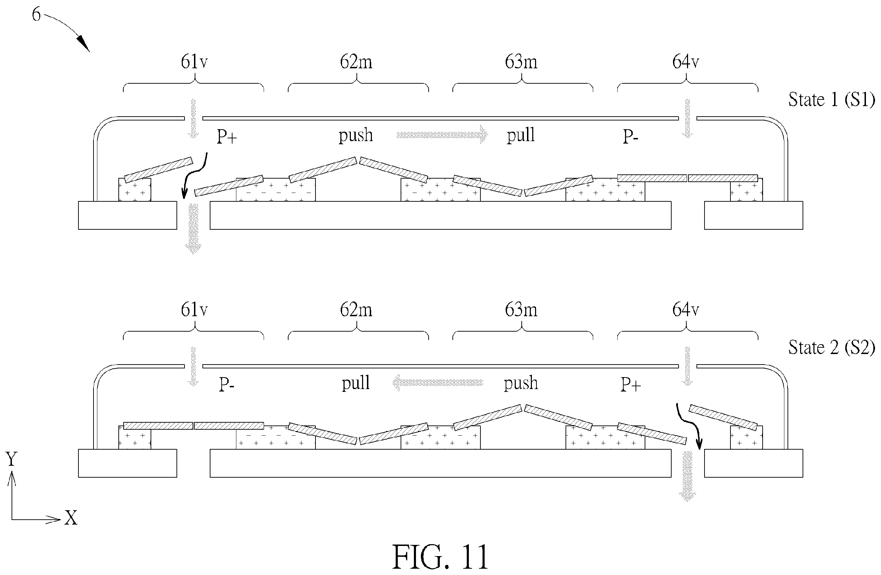

In FIG. 11, the airflow generating device 6 comprises flap pairs 61v, 62m, 63m and 64v. The flap pairs 62m and 63m (solely/mainly) perform common-mode movement to push or pull the volume above the flap pairs 62m and 63m, resulting in positive/negative air pressure P+/P-. The flap pairs 61v and 64v (solely/mainly) perform differential-mode movement, synchronized with the common-mode movement.

Taking advantage of acoustic mode in the chamber, two push-pull flap pairs 62m and 63m can drive the chamber pressure into acoustic resonance. Controlling the valve open time to be synchronized with the ultrasound acoustic pressure difference would generate the airflow. Even number of flap pairs performing common-mode movements (e.g., 62m and 63m) or even number of flap pairs performing differential-mode movements (e.g., 61v and 64v) may allow possibility of energy recycle in electrical/mechanical/acoustic domain, which may make the system more efficient.

## Claims

1. An airflow generating device, **characterised by,** comprising:
a first cell (10), disposed within a first region (Rg1); and
a second cell (20), disposed within a second region (Rg2);
wherein the first cell generates a first air pressure with a first polarity in the first region and the second cell generates a second air pressure with a second polarity in the second region;
wherein the second polarity is opposite to the first polarity.

2. The airflow generating device of claim 1,
**characterised in that,** the first cell comprises a first film structure and the second cell comprises a second film structure;
wherein the first film structure moves toward a first direction and the second film structure moves toward a second direction opposite to the first direction.

3. The airflow generating device of claim 1,
**characterised in that,** the first cell comprises a first flap pair and the second cell comprises a second flap pair;
wherein one of the first flap pair and the second flap pair comprises a first flap and a second flat opposite to each other.

4. The airflow generating device of claim 3,
**characterised in that,** the first flap pair performs a first common-mode movement and the second flap pair performs a second common-mode movement;
wherein the first flap pair performs the first common-mode movement to move toward a first direction and the second flap pair performs the second common-mode movement to move toward a second direction opposite to the first direction.

5. The airflow generating device of claim 3,
**characterised in that,** the first flap pair performs a first differential-mode movement to form a first virtual valve;
wherein the second flap pair performs a second differential-mode movement to form a second virtual valve;
wherein the second virtual valve is in a close state when the first virtual valve is in an open state.

6. The airflow generating device of claim 3,
**characterised in that,** the first flap pair performs a first common-mode movement and performs a first differential-mode movement to form a first virtual valve;
wherein the second flap pair performs a second common-mode movement and performs a second differential-mode movement to form a second virtual valve;
wherein the second virtual valve is in an open state when the first flap pair performs the first common-mode movement to move toward a first direction to compress the volume over the first flap pair.

7. The airflow generating device of claim 1,
**characterised in that,** one of the first and second cells comprises a flap pair;
wherein the flap pair performs a common-mode movement to compress or expand a volume over the flap pair;
wherein the flap pair performs a differential-mode movement to form a virtual valve; wherein the flap pair performs the common-mode movement and the differential-mode movement simultaneously;
wherein the virtual valve is closed while the common-mode movement of the flap pair moves toward a first direction;
wherein the virtual valve is opened while the common-mode movement of the flap pair moves toward a second direction opposite to the first direction.

8. The airflow generating device of claim 1,
**characterised in that,** the first cell comprises a first flap pair and the second cell comprises a second flap pair;
wherein the first flap pair compresses a first volume over the first region, and a first virtual valve formed by the first flap pair is closed;
wherein the second flap pair expands a second volume over the second region, and a second virtual valve formed by the second flap pair is opened.

9. The airflow generating device of claim 1,
**characterised in that,** one of the first and second cells comprises a flap pair;
wherein the flap pair receives a pair of differential-mode signals and a common-mode signal.

10. The airflow generating device of claim 1,
**characterised in that,** the flap pair receives the pair of differential-mode signals corresponding to a differential-mode frequency and the common-mode signal corresponding to a common-mode frequency;
wherein the differential-mode frequency is a half or a quarter of the common-mode frequency.

11. The airflow generating device of claim 1,
**characterised in that,** the first cell comprises a first flap pair and the second cell comprises a second flap pair;
wherein the first flap pair receives a first differential-mode signal and the second flap pair receives a second differential-mode signal;
wherein the first differential-mode signal and the second differential-mode signal have a phase difference of π/4;
wherein the first cell comprises a first flap pair and the second cell comprises a second flap pair;
wherein the first flap pair receives a first common-mode signal and the second flap pair receives a second common-mode signal;
wherein the first common-mode signal and the second common-mode signal have a phase difference of π/2.

12. The airflow generating device of claim 1, **characterised by,** comprising:
a plurality of first cells, disposed in the first region; and
a plurality of second cells, disposed in the second region.

13. The airflow generating device of claim 1, **characterised by,** comprising:
a covering structure, disposed over the first cell and the second cell;
wherein an opening is formed between the first region and the second region;
wherein the opening has an elongated shape.

14. The airflow generating device of claim 1, **characterised by,** comprising:
a third cell and a fourth cell;
wherein the first cell (10) is disposed within a first sub-region (rg11) of the first region;
wherein the second cell (20) is disposed within a first sub-region (rg21) of the second region;
wherein the third cell (30) is disposed within a second sub-region (rg12) of the first region;
wherein the fourth cell (40) is disposed within a second sub-region (rg22) of the second region;
wherein the first sub-region of the first region is adjacent to the first sub-region of the second region in a first direction (X1);
wherein the first sub-region of the first region is adjacent to the second sub-region of the second region in a second direction (X2);
wherein the first cell and third cell generate the first air pressure with the first polarity in the first region;
wherein the second cell and fourth cell generate the second air pressure with the second polarity in the second region;
wherein the first and third cells receive a first differential-mode signal and a first common-mode signal;
wherein the second and fourth cells receive a second differential-mode signal and a second common-mode signal.

15. The airflow generating device of claim 14, **characterised by,** comprising:
a covering structure, disposed over the first cell, the second cell, the third cell and the fourth cell;
wherein a first opening is formed between the first sub-region of the first region and the first sub-region of the second region;
wherein a second opening is formed between the first sub-region of the first region and the second sub-region of the second region.

16. The airflow generating device of claim 14, **characterised by,** comprising:
a plurality of first cells, disposed in the first sub-region of the first region;
a plurality of second cells, disposed in the first sub-region of the second region;
a plurality of third cells, disposed in the second sub-region of the first region; and
a plurality of fourth cells, disposed in the second sub-region of the second region;
wherein the first cells and third cells generate the first air pressure with the first polarity in the first region;
wherein the second cells and fourth cells generate the second air pressure with the second polarity in the second region.

17. A method of generating airflow for an airflow generating device, **characterised by,** comprising:
generating, by a first cell, a first air pressure with a first polarity in a first region; and
generating, by a second cell, a second air pressure with a second polarity in a second region;
wherein the airflow generating device comprises the first cell and the second cell;
wherein the second polarity is opposite to the first polarity.

18. The method of claim 17, **characterised by,** comprising:
compressing a first volume of the first region by the first cell; and
expanding a second volume of the second region by the second cell.

19. The method of claim 17, **characterised by,** comprising:
actuating a first film structure to move toward a first direction;
actuating a second film structure to move toward a second direction opposite to the first direction;
wherein the first cell comprises the first film structure and the second cell comprises the second film structure.

20. The method of claim 17, **characterised by,** comprising:
performing a first common-mode movement, by a first flap pair, toward a first direction; and
performing a second common-mode movement, by a second flap pair, toward a second direction opposite to the first direction;
actuating a first flap pair by a first differential-mode signal and a first common-mode signal;
actuating a second flap pair by a second differential-mode signal and a second common-mode signal;
wherein the first cell comprises the first flap pair and the second cell comprises the second flap pair;
wherein the first differential-mode signal and the second differential-mode signal have a phase difference of π/4;
wherein the first common-mode signal and the second common-mode signal have a phase difference of π/2.

21. An airflow generating device, **characterised by**, comprising:
a film structure (42m), configured to perform a movement to push or pull a volume over the film structure to generate a positive pressure and a negative pressure;
a flap pair (41v), comprising a first flap and a second flap opposite to each other, configured to perform a differential movement to form a virtual valve;
wherein the differential movement performed by the flap pair is synchronized with the movement performed by the film structure;
wherein an airflow is formed when the virtual valve is opened.
